Europäisches Patentamt

European Patent Office

Office européen des brevets

(11) Numéro de publication: **0 330 954 B1**

## FASCICULE DE BREVET EUROPEEN

(45) Date de publication de fascicule du brevet: **25.11.92**

(51) Int. Cl.5: **H03L 7/26**, H01S 1/06, G04F 5/14

(21) Numéro de dépôt: **89102885.4**

(22) Date de dépôt: **20.02.89**

(54) Etalon de fréquence passif.

(30) Priorité: **29.02.88 FR 8802593**

(43) Date de publication de la demande:
**06.09.89 Bulletin 89/36**

(45) Mention de la délivrance du brevet:
**25.11.92 Bulletin 92/48**

(84) Etats contractants désignés:
**CH DE ES GB IT LI**

(56) Documents cités:
**FR-A- 2 477 766**
**FR-A- 2 506 531**

**IEEE TRANSACTIONS ON INSTRUMENTA-TION AND MEASUREMENT, vol. IM-36, no. 2, juin 1987, pages 596-603, IEEE, New York, N.Y., US; F.L. WALLS: "Characteristics and performance of miniature NBS passive hydrogen masers"**

**LASER FOCUS, vol. 18, no. 2, février 1982, pages 18,20, Newton, Mass., US; "Laser diode improves lifetime and accuracy of atomic clocks"**

(73) Titulaire: **OSCILLOOUARTZ S.A.**
**Rue des Brévards 16**
**CH-2002 Neuchâtel(CH)**

(72) Inventeur: **Busca, Giovanni**
**Chemin de L'Ecluse 11**
**CH-2022 Bevaix(CH)**
Inventeur: **Leland, Johnson**
**Rue Fritz Courvoisier 98**
**CH-2300 La Chaux-de-Fonds(CH)**

(74) Mandataire: **de Montmollin, Henri et al**
**ICB Ingénieurs Conseils en Brevets SA Passage Max Meuron 6**
**CH-2001 Neuchâtel(CH)**

Rank Xerox (UK) Business Services

ELEKTRONIK, vol. 22, no. 12, 1974, pages 457-460; E. JECHART: "Rubidium-Gaszellenfrequenznormal in Miniaturausführung"

PROCEEDINGS OF THE 40TH ANNUAL FREQUENCY CONTROL SYMPOSIUM, Philadelphia, Pennsylvania, 1986, pages 470-473, IEEE, New York, US; W. WEIDEMANN: "Subminiature rubidium oscillator model FRS"

## Description

La présente invention concerne un étalon de fréquence passif, tels que les étalons de fréquence de type cellule à gaz ou de type maser passif.

Elle se rapporte plus particulièrement à une structure du moyen d'interrogation de l'étalon de fréquence qui permet de réduire le volume de cet étalon de fréquence.

Les étalons de fréquence passifs comprennent de manière connue un moyen de stockage, soumis à un champ magnétique constant, pour stocker des éléments atomiques ou moléculaires sous forme de gaz, un moyen pour produire une inversion de population en mettant ces éléments dans un niveau d'énergie déterminé, un moyen d'interrogation pour stimuler à une fréquence déterminée une transition de niveau d'énergie de ces éléments, et un moyen d'asservissement pour commander la fréquence du moyen d'interrogation en fonction d'un signal dépendant de la radiation émise par la transition stimulée.

Le principe général de fonctionnement des étalons de fréquence, et en particulier des étalons de fréquence passifs, est décrit notamment dans l'article "les horloges atomiques" par C. Steiner paru dans le numéro de février-mars 1967 de la revue "la Suisse Horlogère" éditée par la Chambre Suisse de l'Horlogerie.

Des modes de réalisation d'un étalon atomique de fréquence passif à cellule à gaz et d'un maser passif sont décrits respectivement dans les documents CH-A-640 370 et US-A-4 316 153.

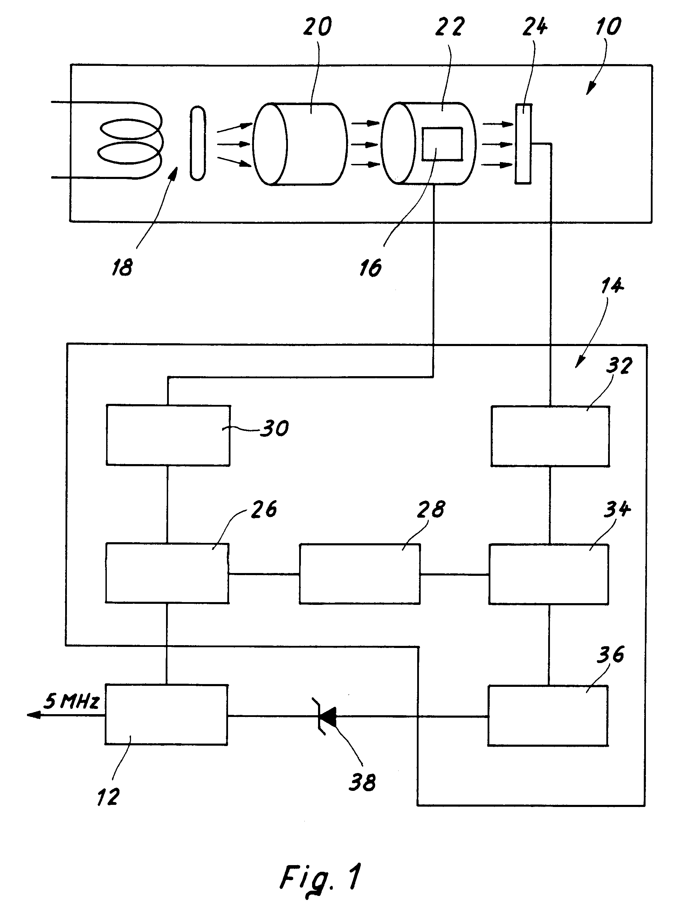

A titre d'exemple d'étalon de fréquence passif connu, on va maintenant décrire un étalon atomique de fréquence à cellule à gaz en référence à la figure 1.

Cet étalon de fréquence comprend essentiellement un dispositif de pompage optique 10, un oscillateur à quartz 12 et un circuit électronique 14 comparant la fréquence de résonance du système atomique à celle de l'oscillateur pour l'asservissement de cette dernière.

Dans le dispositif 10, on produit par pompage optique une inversion de population entre les niveaux hyperfins de l'état fondamental d'atomes qui sont généralement des métaux alcalins tels que le potassium, le sodium ou le rubidium. Dans le cas d'un étalon de fréquence au rubidium, un montage classique de pompage optique est le suivant.

Une cellule 16 contient l'isotope Rb 87 dont le spectre comprend les deux composantes hyperfines A et B. La cellule est illuminée par une lampe 18 au rubidium 87 à travers un filtre 20 qui contient l'isotope Rb 85 dont le spectre d'absorption comporte les composantes hyperfines a et b. Les composantes A et a sont pratiquement en coïncidence, tandis que les composantes B et b sont complètement séparés. La composante A du spectre d'émission de la lampe 18 est ainsi éliminée par le filtre 20 de sorte que la lumière qui atteint la cellule 16 est constituée en majeure partie par la raie B. Seuls les atomes de Rb 87 de la cellule 16 situés dans le niveau hyperfin inférieur (F = 1) absorbent de la lumière et sont portés dans des états supérieurs. Ils retournent par émission spontanée soit sur le niveau hyperfin supérieur (F = 2) soit sur le niveau hyperfin inférieur. Comme les atomes sont aussitôt excités par l'arrivée de la lumière, le niveau inférieur (F = 1) se vide au profit du niveau supérieur (F = 2). Il se réalise alors l'inversion de population entre ces deux niveaux et, de ce fait, la cellule 16 devient pratiquement transparente au rayonnement de la lampe 18.

La cellule 16 est disposée dans une cavité micro-onde 22 qui est excitée à une fréquence proche de 6835 MHz, correspondant à l'énergie de séparation des niveaux hyperfins $F = 1$, $m_F = 0$ et $F = 2$, $m_F = 0$, ce qui provoque la transition hyperfine, accompagnée d'une émission de rayonnement électromagnétique entre ces deux niveaux. Dès que les atomes qui participent à l'émission stimulée arrivent sur le niveau hyperfin inférieur (F = 1), ils sont pompés optiquement et portés dans les états excités.

Plus le nombre de transitions stimulées est grand, plus la quantité de lumière absorbée dans la cellule 16 est grande, plus la quantité de lumière arrivant sur une cellule photoélectrique 24 est petite et plus le courant dans la cellule photoélectrique 24 sera petit. Ce courant photoélectrique passe par un minimum lorsque la fréquence du signal d'excitation de la cavité est exactement égale à la fréquence de transition.

L'oscillateur à quartz 12 produit un signal à 5 MHz. Ce signal est modulé dans un modulateur de phase 26, à une fréquence relativement basse (typiquement de l'ordre de 100 Hz) produite par un générateur BF 28.

Le signal modulé est appliqué à un multiplicateur-synthétiseur 30 pour obtenir un signal ayant la fréquence de l'émission stimulée de 6835 MHz. C'est ce signal qui est utilisé pour exciter la cavité micro-onde 22.

Le signal délivré par la cellule photoélectrique 24 est reçu dans un amplificateur 32, puis appliqué à un comparateur de phase 34 qui recoit également un signal de référence du générateur BF 28 de manière à effectuer une détection synchrone permettant de détecter si la fréquence porteuse du signal appliqué à la cavité 22 est bien centrée sur la fréquence de la transition hyperfine (6835 MHz). Tout décalage se traduit par un signal d'erreur à la sortie du comparateur de phase 34. Ce signal est amené à un intégrateur 36, puis utilisé pour commander une capacité variable 38 couplée à l'oscillateur 12 et qui modifie la fréquence de celui-ci de manière à maintenir la fréquence multipliée du quartz centrée sur la fréquence de la transition hyperfine du rubidium.

L'étalon de fréquence classique représenté sur la figure 1 comporte une cavité résonnante cylindrique 22. Celle-ci constitue une limitation à la miniaturisation de l'étalon de fréquence.

En effet, la cavité résonnante doit avoir des dimensions très supérieures à celles de la cellule pour que cette dernière soit soumise à un champ essentiellement axial. Par ailleurs, les dimensions de la cavité résonnante ne peuvent pas être choisies librement, mais dépendent au contraire de la fréquence de résonance voulue.

La figure 1 illustre la structure générale d'un étalon de fréquence passif de type cellule à gaz. Les masers passifs présentent le même type de limitation quant à la miniaturisation. En effet, le dispositif de pompage optique 10 est remplacé dans les masers passifs par un dispositif comprenant un ballon de stockage percé d'une ouverture et placé dans une cavité résonnante, une source de gaz, tel que l'hydrogène atomique, émettant un faisceau de particules vers l'ouverture du ballon de stockage, et un moyen de sélection d'état placé sur la trajectoire du faisceau et qui dévie les particules qui ne sont pas dans un état d'énergie déterminé. On obtient ainsi une inversion de population dans le ballon de stockage. Le dispositif comprend également une boucle de couplage pour détecter la radiation émise par l'émission stimulée.

Les masers passifs et les cellules à gaz comportent donc tous les deux une cavité résonnante, ce qui limite les possibilités de miniaturisation de ces étalons de fréquence.

L'invention a pour but de rendre les étalons de fréquence passifs plus compacts. Ce but est atteint par une nouvelle structure de moyen de résonance.

De manière précise, l'invention a pour objet un étalon de fréquence passif comprenant un moyen de stockage, soumis à un champ magnétique constant, pour stocker des éléments atomiques ou moléculaires sous forme de gaz, un moyen d'inversion pour produire dans ledit moyen de stockage des éléments ayant un premier état d'énergie, un moyen d'interrogation pour stimuler à une fréquence déterminée une transition de niveau d'énergie des éléments ayant le premier niveau d'énergie et un moyen d'asservissement pour commander la fréquence déterminée du moyen d'interrogation en fonction d'un signal dépendant de la radiation émise par ladite transition stimulée, cet étalon de fréquence étant caractérisé en ce que le moyen d'interrogation comprend un résonateur hélicoïdal dans lequel est placé le moyen de stockage.

La fréquence de résonance de l'hélice dépend de son pas p (ou de son angle d'attaque $\psi$) de son diamètre D et de sa longueur L. Une même fréquence de résonance peut ainsi être obtenue avec des hélices différentes. Ceci permet de choisir dans chaque cas le format d'hélice le plus adapté.

Les caractéristiques et avantages de l'invention ressortiront mieux de la description qui va suivre, donnée à titre illustratif mais non limitatif, en référence aux dessins annexés, sur lesquels :

- la figure 1, déjà décrite, représente schématiquement un étalon de fréquence passif selon l'art antérieur,
- la figure 2 est une coupe d'un dispositif de pompage optique d'un étalon de fréquence à cellule à gaz selon l'invention,
- la figure 3 illustre la distribution du champ magnétique dans le résonateur hélicoïdal, et
- la figure 4 représente schématiquement un maser passif comprenant un moyen d'interrogation selon l'invention.

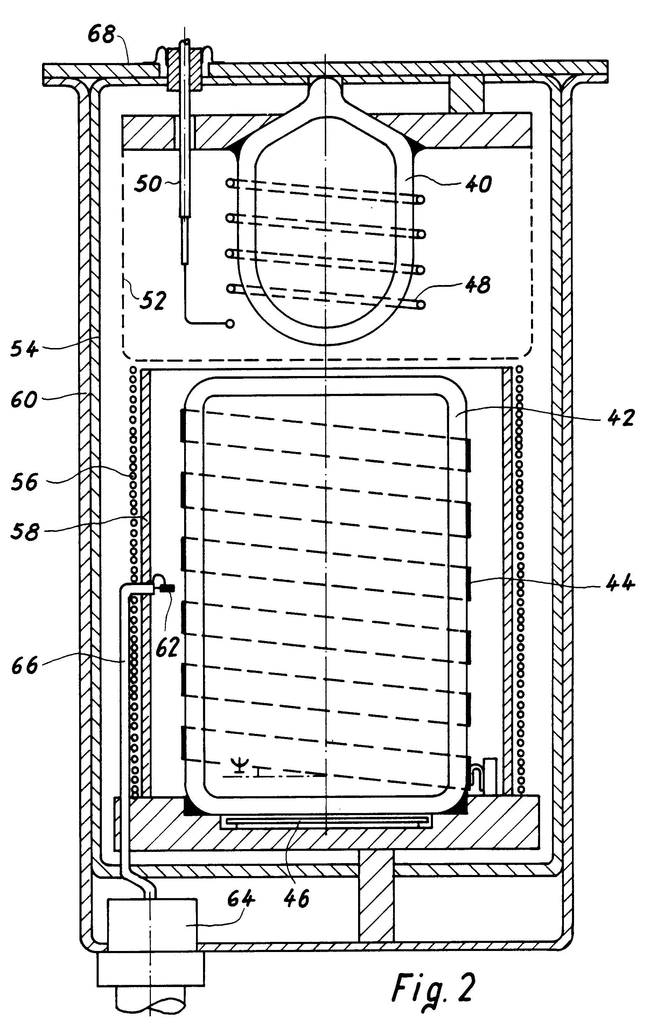

Le dispositif selon l'invention représenté sur la figure 2 comprend essentiellement une lampe 40, une cellule à gaz 42, un résonateur hélicoïdal 44 et une cellule photoélectrique 46.

La lampe 40 contient principalement du Rb 87, ainsi que de l'argon à la pression de 2 Torr servant de gaz d'amorce. Elle est placée dans une bobine d'excitation 48 reliée à un câble coaxial 50 qui reçoit d'un oscillateur radiofréquence un signal de fréquence comprise entre 100 et 150 MHz environ. Une grille 52 est disposée autour de l'ensemble pour éviter le rayonnement de ce signal vers la cellule à gaz et la cellule photoélectrique.

Un circuit de chauffage classique (non représenté) comprenant une résistance chauffante et un capteur de température est utilisé pour maintenir la lampe à sa température normale de fonctionnement.

La cellule à gaz 42 est placée en regard de la lampe 40. Dans l'exemple représenté, cette cellule contient du Rb 85 et du Rb 87, ainsi qu'un gaz tampon qui peut être un mélange d'azote à la pression partielle de 8 Torr et de méthane à la pression partielle de 5 Torr. Elle a un diamètre de 16 mm et une longueur de 25 mm, soit un volume de 5 cm$^3$ environ.

Cette cellule constitue à la fois le filtre isotopique et la cellule d'absorption du dispositif de pompage optique de la figure 1.

Les atomes de Rb 85 situés dans la partie de la cellule 42 la plus proche de la lampe 40 absorbent la composante spectrale A de celle-ci, ce qui réalise le filtrage, et les atomes de Rb 87 situés dans la partie de la cellule 42 la plus éloignée de la lampe 40 absorbent la composante spectrale 8 de celle-ci, ce qui réalise le pompage optique.

Il est bien entendu également possible d'utiliser un filtre isotopique et une cellule d'absorption séparés, mais le mode de réalisation représenté sur la figure 2 présente l'avantage d'une plus grande compacité.

Dans tous les cas, la cellule 42 est munie de moyens classiques (non représentés) de chauffage et de contrôle de température pour maintenir sa température à sa valeur normale de fonctionnement.

Une variante de réalisation également avantageuse pour son encombrement réduit consiste à remplacer la lampe 40 par une diode laser. En effet, celle-ci a un spectre suffisamment étroit pour ne contenir que la composante spectrale 8. Le filtre isotopique qui sert à absorber la composante A n'est alors plus nécessaire. On peut ainsi réduire la taille de la cellule 42.

La cellule 42 est protégée des champs magnétiques extérieurs par un écran magnétique 54. La cellule 42 est soumise à un champ magnétique constant créé par une bobine 56 et à un champ magnétique radiofréquence créé par un moyen d'interrogation qui, conformément à l'invention, comprend un résonateur hélicoïdal 44. Ce champ magnétique radiofréquence est confiné par un écran conducteur 58.

La fréquence de résonance est fonction de la géométrie de l'hélice $\psi$. Par exemple, la longueur L est déterminée par la relation $L = (2n + 1).(\lambda/4).k.tg \psi$, où $\lambda$ est la longueur d'onde de résonance dans le vide, $\psi$ est l'angle d'attaque de l'hélice, n est un entier et k est un coefficient proche de 1 tenant compte de l'écran conducteur 58.

Ainsi, une fréquence de résonance de 6835 MHz, soit $\lambda = 4,39$ cm, qui correspond à la fréquence de transition hyperfine du niveau $F = 2$, $m_F = 0$ au niveau $F = 1$, $m_F = 0$ pour les atomes de Rb 87 est obtenue avec $L = 17,9$ mm pour $n = 7$ et $\psi = 5,7°$. On constate donc qu'il est possible de construire un résonateur hélicoïdal ayant des dimensions comparables à celles de la cellule. Ceci permet une réduction de volume importante par rapport aux étalons de fréquence classiques comportant une cavité résonante.

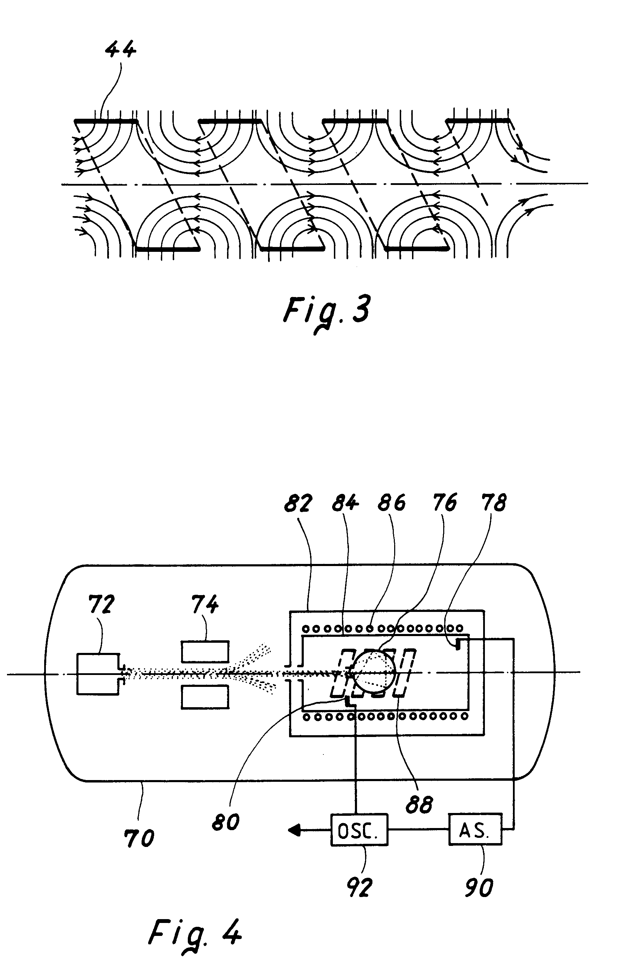

On a représenté schématiquement sur la figure 3 la distribution du champ magnétique dans le résonateur hélicoïdal. On constate que ce champ est essentiellement axial. Le facteur de remplissage du résonateur est donc élevé car la cellule peut occuper efficacement tout le volume du résonateur.

Le résonateur peut être appliqué sur la cellule 42 comme représenté sur la figure 2; ceci peut être réalisé par exemple par évaporation sous vide d'un métal. Le résonateur peut être placé également autour de la cellule sans contact avec celle-ci.

Le résonateur hélicoïdal 44 est excité par une boucle micro-onde 62, disposée dans un plan perpendiculaire à l'axe de l'hélice, et alimentée par un oscillateur extérieur par l'intermédiaire d'un connecteur 64 et d'un câble coaxial 66. La boucle 62 peut comprendre une diode SRD (step recovery diode) qui multiplie la fréquence du signal délivré par l'oscillateur et qui permet ainsi d'utiliser un oscillateur de relativement basse fréquence.

L'absorption de la composante spectrale B par les atomes de Rb 87 de la cellule 42 est détectée par la cellule photoélectrique 46. Ce signal d'absorption est utilisé de manière classique pour asservir la fréquence du signal d'interrogation émis par la boucle 62 à la fréquence de la transition hyperfine du niveau $F = 2$, $m_F = 0$ au niveau $F = 1$, $m_F = 0$ du Rb 87.

Des essais expérimentaux ont montré que la dérive à long terme de l'étalon de fréquence représenté sur la figure 2 est inférieur à $10^{-11}$ mois. De même, la stabilité de fréquence à court terme $\sigma (\tau)$ (variance ALLAN) est meilleure que $5.10^{-12} .\tau^{-1/2}$ pour $1 < \tau < 100$ secondes.

Le dispositif selon l'invention représenté sur la figure 2 présente un volume de 35 cm³ environ (diamètre de 3 cm et longueur de 5 cm). Ceci permet de réduire le temps de chauffage initial (en anglais "warm up time") à environ 1 mn pour atteindre une erreur de fréquence inférieure à $5.10^{-10}$.

Le conteneur formé par l'enveloppe 60 et le couvercle 68 peut être mis avantageusement sous vide. Ceci procure plusieurs avantages par rapport à l'art antérieur dans lequel la lampe et la cellule ne sont pas sous vide.

Premièrement, le flux thermique dû à la convection entre la lampe 40 et la cellule 42 (dont les températures respectives sont par exemple de 140° C et 80° C) est supprimé ce qui permet un réglage précis des deux températures.

Deuxièmement, la mise sous vide du conteneur permet de rapprocher sans dommage la lampe et la cellule, ce qui entraîne une réduction supplémentaire de volume du conteneur.

Troisièmement, le domaine de température et la stabilité de fréquence dans ce domaine sont améliorés. Le dispositif selon l'invention a un domaine de température de - 55° C à + 75° C, avec une stabilité de fréquence de $3.10^{-10}$ sur cette gamme, soit $2.3 \ 10^{-12}/°$ C.

Quatrièmement, la mise sous vide permet de diminuer la consommation de puissant. Le dispositif selon l'invention représenté sur la figure 2 consomme une puissance de 7 W.

On a représenté sur la figure 2 un étalon de fréquence à cellule à gaz comprenant, conformément à l'invention, un résonateur hélicoïdal. Ce résonateur peut être employé également dans d'autres étalons de fréquence passifs, tel qu'un maser passif comme on l'a représenté schématiquement sur la figure 4.

Celui-ci comprend essentiellement, dans un conteneur sous vide 70, une source de gaz 72, un sélecteur d'état 74, un ballon de stockage 76 , une boucle de détection 78 et une boucle d'interrogation 80. Le ballon de stockage 76 est isolé des champs magnétiques extérieurs par un écran magnétique 82; il est soumis à un champ magnétique constant engendré par une bobine 86 et à un champ magnétique à la fréquence de résonance produit par un résonateur hélicoïdal 88 selon l'invention et confiné par un écran conducteur 84.

La boucle 78 est reliée à l'extérieur du conteneur 70 à un moyen d'asservissement 90 qui asservit la fréquence d'un oscillateur 92 dont le signal est appliqué à la boucle 80.

La source de gaz 72 émet en direction de l'ouverture du ballon de stockage 76 un jet d'atomes ou de molécules qui sont généralement de l'hydrogène atomique ou un métal alcalin. Le sélecteur d'état 74 engendre un champ magnétique très inhomogène qui élimine par divergence les atomes ou molécules qui ne sont pas dans l'état d'énergie désiré.

Par exemple, dans le cas de l'hydrogène atomique le sélecteur d'état 74 élimine les atomes dans l'état d'énergie inférieur $F = 0$, $m_F = 0$. Les atomes atteignant le ballon de stockage sont ceux qui sont dans les états d'énergie supérieurs $F = 1$, $m_F = 0$ ou $+ 1$. On obtient ainsi une inversion de population dans le ballon de stockage.

La transition stimulée de l'état $F = 1$, $m_F = 0$ à l'état $F = 0$, $m_F = 0$ est déclenchée par le résonateur excité par l'oscillateur. La fréquence de résonance est ajustée à 1420 MHz en choisissant des valeurs adéquates pour le pas p, le diamètre D et la longueur L de l'hélice.

Le maser passif représenté sur la figure 4 fonctionne selon le même principe que l'étalon de fréquence à cellule à gaz représenté sur la figure 2. Les seules différences résident dans le mode de réalisation de l'inversion de population et dans la nature du moyen de détection utilisé.

## Revendications

1. Etalon de fréquence passif comprenant un moyen de stockage (42, 76), soumis à un champ magnétique constant, pour stocker des éléments atomiques ou moléculaires sous forme de gaz, un moyen d'inversion (72, 74) pour produire dans ledit moyen de stockage des éléments ayant un premier état d'énergie, un moyen d' interrogation (92) pour stimuler à une fréquence déterminée une transition de niveau d'énergie des éléments ayant ledit premier niveau d'énergie et un moyen d'asservissement (90) pour commander la fréquence déterminée dudit moyen d'interrogation en fonction d'un signal dépendant de la radiation émise par ladite transition stimulée, ledit étalon de fréquence passif étant caractérisé en ce que ledit moyen d'interrogation comprend un résonateur hélicoïdal (44, 88), ledit moyen de stockage étant placé à l'intérieur dudit résonateur hélicoïdal.

2. Etalon de fréquence passif selon la revendication 1 caractérisé en ce que ledit moyen d'interrogation comprend une boucle conductrice (62, 80) parcourue par un signal électrique périodique dont la fréquence est égale à ladite fréquence déterminée.

3. Etalon de fréquence passif selon la revendication 1 caractérisé en ce que ledit moyen d'interrogation comprend une boucle conductrice et une diode SRD en série parcourues par un signal électrique périodique dont la fréquence est égale à ladite fréquence déterminée ou à un sous-multiple de ladite fréquence déterminée.

4. Etalon de fréquence passif selon l'une quelconque des revendications 1 à 3, de type cellule à gaz, caractérisé en ce que ledit moyen de stockage est une cellule (42) contenant un métal alcalin sous forme de gaz et en ce que ledit moyen d'inversion comprend une source de lumière (40) de composante spectrale déterminée qui produit par pompage optique une inversion de population dans ladite cellule.

5. Etalon de fréquence passif selon la revendication 4 caractérisé en ce que ladite source de lumière comprend une diode laser.

6. Etalon de fréquence passif selon la revendication 5 caractérisé en ce que ledit moyen de stockage contient du Rb 87 et un gaz tampon.

7. Etalon de fréquence passif selon la revendication 4 caractérisé en ce que ladite source de lumière comprend une lampe à vapeur de métal alcalin et un filtre isotopique.

8. Etalon de fréquence passif selon la revendication 7 caractérisé en ce que ladite lampe à vapeur de métal alcalin est une lampe au Rb 87, ledit filtre comporte une cellule de Rb 85 et la cellule formant ledit moyen de stockage contient du Rb 87.

9. Etalon de fréquence passif selon la revendication 8 caractérisé en ce qu'il comporte une cellule (42) unique contenant du Rb 85, du Rb 87 et un gaz tampon.

**10.** Etalon de fréquence passif selon l'une quelconque des revendications 4 à 9 caractérisé en ce que ladite source de lumière, ledit moyen de stockage et ledit résonateur hélicoïdal dudit moyen d'interrogation sont dans un conteneur (56, 58) sous vide.

**11.** Etalon de fréquence passif selon l'une quelconque des revendications 4 à 10 caractérisé en ce que ledit moyen d'asservissement comporte une cellule photoélectrique (46) détectant la lumière de composante spectrale déterminée ayant traversé le moyen de stockage.

**12.** Etalon de fréquence passif selon l'une quelconque des revendications 1 à 3, de type maser passif, caractérisé en ce ledit moyen de stockage (76) comporte une ouverture et en ce que ledit moyen d'inversion comprend une source de gaz (72) et un sélecteur d'état (74) pour diriger dans ledit moyen de stockage les éléments ayant ledit premier niveau d'énergie.

**13.** Etalon de fréquence passif selon la revendication 12 caractérisé en ce que la source de gaz émet de l'hydrogène atomique.

**14.** Etalon de fréquence passif selon la revendication 13 caractérisé en ce que le moyen d'asservissement comporte une boucle conductrice de couplage (78) pour détecter la radiation émise par ladite transition stimulée.

**Claims**

**1.** Passive frequency standard comprising storage means (42, 76), subjected to an uniform static magnetic field, for storing atomic or molecular elements in gaseous form, inversion means (72, 74) for producing elements within the storage means having a first energy state, interrogation means (92) for stimulating at a predetermined frequency a transition of energy level of the elements having said first energy level and slave means (90) for controlling the predetermined frequency of said interrogation means as a function of a signal depending from the radiation emitted by said stimulated transition, said passive frequency standard being characterized in that said interrogation means comprises a helicoidal resonator (44, 88), said storage means being situated within said helicoidal resonator.

**2.** Passive frequency standard according to claim 1, characterized in that said interrogation means comprises a conductive loop (62, 80) carrying a periodic electric signal the frequency of which is equal to said predetermined frequency.

**3.** Passive frequency standard according to claim 1, characterized in that said interrogation means comprises a conductive loop and an SRD diode in series therewith carrying a periodic electric signal the frequency of which is equal to said predetermined frequency or to a sub-multiple of said predetermined frequency.

**4.** Passive frequency standard according to any one of claims 1 to 3, of the gas cell type, characterized in that said storage means is a cell (42) containing an alkali metal in gaseous form and in that said inversion means comprises a light source (40) having a predetermined spectral component which produces a population inversion within said cell by optical pumping.

**5.** Passive frequency standard according to claim 4, characterized in that said light source comprises a laser diode.

**6.** Passive frequency standard according to claim 5, characterized in that said storage means contains Rb 87 and a gas buffer.

**7.** Passive frequency standard according to claim 4, characterized in that said light source comprises an alkali metal vapour lamp and an isotopic filter.

**8.** Passive frequency standard according to claim 7, characterized in that said alkali metal vapour lamp comprises an Rb 87 lamp, said filter includes an Rb 85 cell and the cell forming said storage means contains Rb 87.

**9.** Passive frequency standard according to claim 8, characterized in that it includes a single cell (42) containing Rb 85, Rb 87 and a gas buffer.

**10.** Passive frequency standard according to any one of claims 4 to 9, characterized in that said light source, said storage means and said helicoidal resonator of said interrogation means are placed in a container (56, 58) under vacuum.

**11.** Passive frequency standard according to any one of claims 4 to 10, characterized in that said slave means includes a photoelectric cell (46) adapted to detect the light of predetermined spectral composition which has traversed the storage means.

**12.** Passive frequency standard according to any one of claims 1 to 3, of the passive maser type, characterized in that said storage means (76) includes an opening and in that said inversion means comprises a source of gas (72) and a state selector means (74) for directing elements at said first energy level into said storage means.

**13.** Passive frequency standard according to claim 12, characterized in that said source of gas emits atomic hydrogen.

**14.** Passive frequency standard according to claim 13, characterized in that said slave means includes a coupling conductive loop (78) for detecting the radiation emitted by said stimulated transition.

**Patentansprüche**

**1.** Passives Frequenznormal, umfassend ein einem konstanten Magnetfeld ausgesetztes Speichermittel (42, 76) zum Speichern von atomaren oder molekularen gasförmigen Elementen, ein Inversionsmittel (72, 74) zum Erzeugen, in dem Speichermittel, von Elementen mit einem ersten Energiezustand, ein Abfragemittel (92) zum Stimulieren, mit einer bestimmten Frequenz, eines Energieniveauübergangs von Elementen, die das erste Energieniveau aufweisen, und ein Regelungsmittel (90) zum Steuern der bestimmten Frequenz des Abfragemittels in Funktion eines Signals, das abhängt von der durch den stimulierten Übergang ausgehenden Strahlung, welches passive Frequenznormal dadurch gekennzeichnet ist, daß das Abfragemittel einen helikoidalen Resonator (44, 88) umfaßt, in dessen Innerem das Speichermittel plaziert ist.

**2.** Passives Frequenznormal nach Anspruch 1, dadurch gekennzeichnet, daß das Abfragemittel eine leitende Schleife (62, 80) umfaßt, durchflossen von einem periodischen elektrischen Signal, dessen Frequenz gleich der bestimmten Frequenz ist.

**3.** Passives Frequenznormal nach Anspruch 1, dadurch gekennzeichnet, daß das Abfragemittel eine leitende Schleife und eine SRD-Diode in Serie umfaßt, durchflossen von einem periodischen elektrischen Signal, dessen Frequenz gleich der bestimmten Frequenz oder einem ganzzahligen Bruchteil der bestimmten Frequenz ist.

**4.** Passives Frequenznormal nach einem der Ansprüche 1 bis 3 vom Gaszellentyp, dadurch gekennzeichnet, daß das Speichermittel eine Zelle (42) ist, die ein alkalisches Metall in Gasform enthält, und daß das Inversionsmittel eine Lichtquelle (40) umfaßt mit bestimmten spektralen Komponenten, die durch optisches Pumpen eine Inversion der Population in der Zelle erzeugt.

**5.** Passives Frequenznormal nach Anspruch 4, dadurch gekennzeichnet, daß die Lichtquelle eine Laserdiode umfaßt.

**6.** Passives Frequenznormal nach Anspruch 5, dadurch gekennzeichnet, daß das Speichermittel Rb 87 und ein Puffergas enthält.

**7.** Passives Frequenznormal nach Anspruch 4, dadurch gekennzeichnet, daß die Lichtquelle eine Alkalimetalldampflampe und ein isotopisches Filter umfaßt.

**8.** Passives Frequenznormal nach Anspruch 7, dadurch gekennzeichent, daß die Alkalimetalldampflampe eine Rb 87-Lampe ist, das Filter eine Rb 85-Zelle umfaßt und die das Speichermittel bildende Zelle Rb 87 enthält.

**9.** Passives Frequenznormal nach Anspruch 8, dadurch gekennzeichnet, daß sie eine einzige Rb 85, Rb 87 und ein Puffergas enthaltende Zelle (42) umfaßt.

**10.** Passives Frequenznormal nach einem der Ansprüche 4 bis 9, dadurch gekennzeichnet, daß die Lichtquelle, das Speichermittel und der helikoidale Resonator des Abfragemittels sich in einem Behältnis (56, 58) unter Vakuum befinden.

**11.** Passives Frequenznormal nach einem der Ansprüche 4 bis 10, dadurch gekennzeichnet, daß das Regelungsmittel eine fotoelektrische Zelle (46) umfaßt, welche das Licht der bestimmten Spektralkomponente erfaßt, die das Speichermittel durchlaufen hat.

**12.** Passives Frequenznormal nach einem der Ansprüche 1 bis 3 vom Typ des passiven Maser, dadurch gekennzeichnet, daß das Speichermittel (76) eine Öffnung umfaßt, und daß das Inversionsmittel eine Gasquelle (72) und einen Zustandsselektor (74) umfaßt zum Dirigieren der Elemente, welche das erste Energieniveau aufweisen in das Speichermittel.

**13.** Passives Frequenznormal nach Anspruch 12, dadurch gekennzeichnet, daß die Gasquelle atomaren Wasserstoff imitiert.

14. Passives Frequenznormal nach Anspruch 13, dadurch gekennzeichnet, daß das Regelungsmittel eine leitende Kopplungsschleife (78) zum Erfassen der Strahlung umfaßt, die von dem stimulierten Übergang ausgeht.

Fig. 1

5 MHz

*Fig. 2*

**Fig. 3**

**Fig. 4**